# EUROPEAN PATENT APPLICATION

(11) **EP 4 757 083 A1**
(43) Date of publication of application: **10.06.2026**
(21) Application number: 25191073.3
(22) Date of filing: 22.07.2025
(51) Int. Cl.: H01S 5/10, H01S 5/22, H01S 5/32, H01S 5/343

(54) **PATTERNED EMBEDDING ON NARROW STRIPE SINGLE MODE TRANSVERSE LASERS**

(30) Priority: 06.12.2024 US 202418971840
(71) Applicant: II-VI Delaware, Inc., Wilmington, DE 19890 (US)
(72) Inventor: MAINEULT, Wilfried, Wilmington, 19890 (US)
(74) Representative: Schmidt, Christian

(57) **Abstract**

Systems and methods are provided for patterned embedding on narrow stripe single mode transverse lasers. An example narrow stripe optical emitter device may include an active region containing semiconductor material, a first embedding region located on a first end of the narrow stripe optical emitter device and containing a first embedding material, and a second embedding region located on a second end of the narrow stripe optical emitter device and containing a second embedding material. The active region may include a ridge running between the first end and the second end of the narrow stripe optical emitter device. The first embedding material may be different from the second embedding material with respect to one or more characteristics. The one or more characteristics may include compressive strain related parameters and/or attributes.

## Description

### TECHNICAL FIELD

Aspects of the present disclosure relate to optical communication based solutions. More specifically, certain implementations of the present disclosure relate to methods and systems for implementing and utilizing patterned embedding on narrow stripe single mode transverse lasers.

### BACKGROUND

Limitations and disadvantages of conventional solutions directed to design, implementation, and use of transverse lasers will become apparent to one of skill in the art, through comparison of such systems with some aspects of the present disclosure as set forth in the remainder of the present application with reference to the drawings.

### BRIEF SUMMARY

System and methods are provided for patterned embedding on narrow stripe single mode transverse lasers, substantially as shown in and/or described in connection with at least one of the figures, as set forth more completely in the claims.

These and other advantages, aspects and novel features of the present disclosure, as well as details of an illustrated embodiment thereof, will be more fully understood from the following description and drawings.

### BRIEF DESCRIPTION OF THE DRAWINGS

Fig. 1A illustrates a cross section of an example high power narrow stripe (NS) laser device.
Fig. 1B illustrates a top view of a ridge profile of an example high power narrow stripe (NS) laser device of Fig. 1A, with the different sections of the laser for maximal single mode power.
Fig. 2A illustrates a cross section of an example high power narrow stripe (NS) laser device, showing forces that may be applied onto the semiconductor material.
Fig. 2B illustrates a relative change of the refractive optical index introduced by stress at the ridge area in an example high power narrow stripe (NS) laser device.
Figs. 3A-3C illustrate schematics of an example two embedding narrow stripe (NS) laser device, with an example process flow to get the desired layers.
Fig. 4 illustrates schematics of an example two embedding narrow stripe (NS) laser device, with an example process flow to get the desired layers.
Fig. 5 is graph illustrating an example alternate implementation with pulsed laser deposition (PLD) technique.
Fig. 6 illustrates an optical microscope image of the transition between the two patterned embeddings in an example two embedding narrow stripe (NS) laser device.

### DETAILED DESCRIPTION

The present disclosure is directed to optical devices (e.g., laser emitters), and solutions for improving operation and/or performance thereof. In particular, solutions in accordance with the present disclosure are directed to improve maximum single mode transverse power of laser devices, and in particular narrow stripe (NS) laser devices. In this regard, techniques described may be applied to all semiconductor transverse single-mode lasers. Such techniques may be used to allow higher optical power to be generated by devices that are used, e.g., as laser pumps, such as in Erbium doped fiber amplifiers (EDFA).

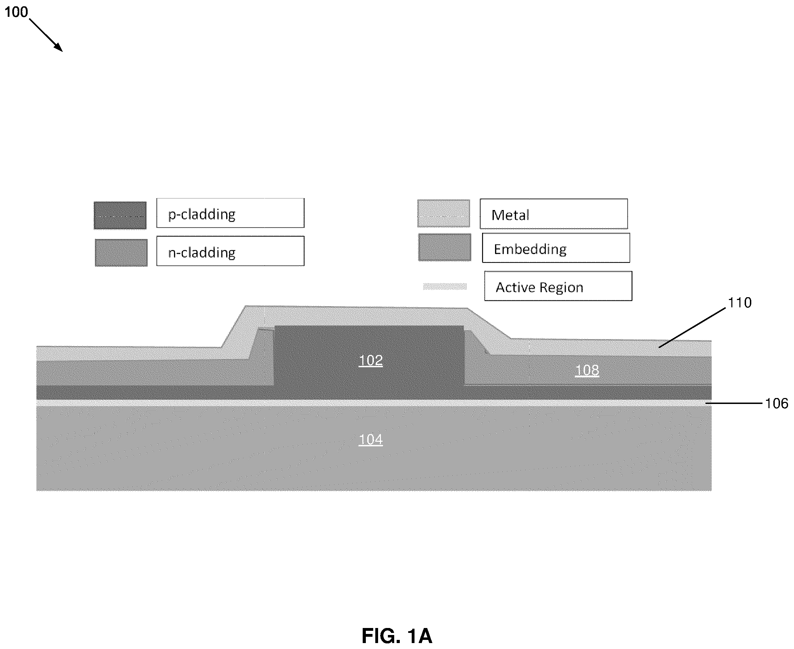

Fig. 1A illustrates a cross section of an example high power narrow stripe (NS) laser device. Shown in Fig. 1A is a narrow stripe (NS) laser device 100 (or cross section thereof).

As illustrated in Fig. 1A, the NS laser device 100 may comprise p-type doped cladding (p-cladding) 102, n-type doped cladding (n-cladding) 104, an active region 106, an embedding 108, and a metal contact layer 110.

In this regard, in various implementations providing high single transverse mode power (that is, linear power), such as at 980 nm, may be achieved by making a relatively long (e.g., >1 mm long) narrow stripe laser (e.g., <15 mm width waveguides), which may be made using Aluminum Gallium Arsenide (AlGaAs) in the claddings / Indium Gallium Arsenide (InGaAs) (in the QW) material. Claddings may also be made from AlInGaP material (for growth on GaAs substrate), or AlGalnAs, AlGaInP (for growth on InP substrate), AlGaN for growth on AIN substrate..., and QW with made of AlGaInP, GaAsN, InGaN, etc. In single mode designs, during epitaxial growth, one-dimensional (1D) optical waveguides may be formed, comprising two claddings (p-cladding 102 and n-cladding 104), with the active region 106 between the two claddings. The active region 106 may comprise, e.g., InGaAs quantum well (QW), emitting light at around 980 nm, for example.

During an example forming process, after epitaxial growth, a two-dimensional (2D) optical waveguide may be formed, such as by etching a ridge waveguide, as shown in Fig. 1A (in the middle part of the NS laser device 110). The etch depth of the waveguide may be defined to ensure the single mode operation. For example, the etch depth may be calculated, and/or details related thereto may be solved analytically for some basic geometries, like step-index optical fiber using suitable approximation and limits. The ridge geometry may also provide the current confinement. The embedding 108 may be deposited everywhere but on top of the ridge, and then the metal contact layer 110 may be deposited on top of the ridge and the embedding 108 to ensure the electrical contact as shown in Fig. 1A.

The embedding 108 may have different purposes, such as: 1) to insulate the laser side walls from the metal contact layer 110 that will come on top, 2) to ensure a stronger confinement of the laser optical mode, and to keep the optical losses low by reducing the overlap of the mode with the metal contact layer 110 on top. The embedding 108 may comprise suitable material for facilitating the purposes thereof. For example, in various implementations, the embedding 108 may comprise oxides, dielectrics, metals that introduce large strain fields, or the like. Further, as shown in Fig. 1A, the the embedding 108 may be asymmetric about the ridge. In this regard, such assymetry may be beneficial (e.g., offering reliability optimization for wafers with different misscuts). Nonetheless, the disclosure is not limited to implementations where the embedding 108 is asymmetric about the ridge, as shown, and as such in some embodments the embedding 108 may be symmetric.

In some implementations, additional layers (either conducting or insulating) may be added and patterned on the wafer for other purposes (e.g., heat extraction, mechanical protection, current blocking, wavelength selectivity, etc.) without affecting much the general behavior of the layer(s) underneath described above.

While the laser device 100 is shown and described herein as narrow stripe (NS) laser device, the disclosure is not limited to such type of lasers, and similar solutions as described herein may be used with other types of laser devices. For example, in some embodiments similar structures similar to the ones described herein may be used in distributed feedback (DFB) laser based devices or Distributed Bragg Reflectors (DBR) ) laser based devices.

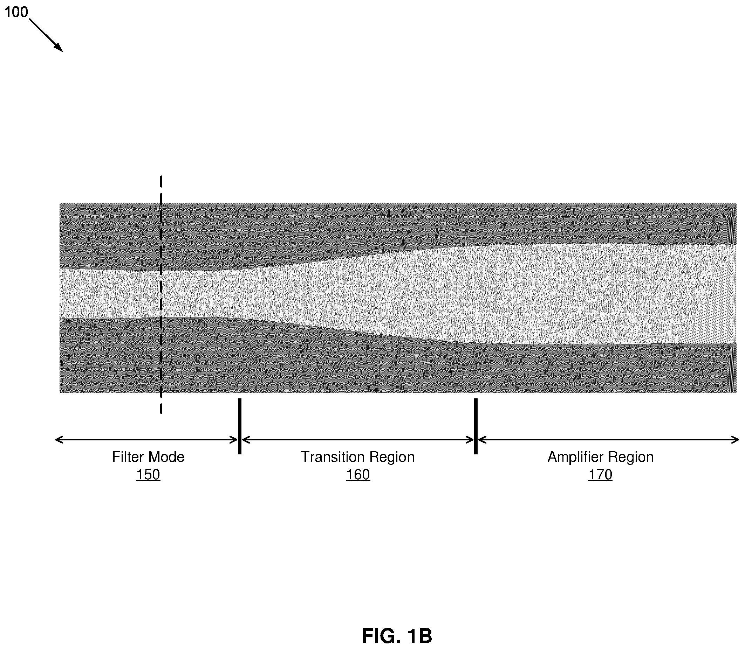

Fig. 1B illustrates a top view of a ridge profile of an example high power narrow stripe (NS) laser device of Fig. 1A, with the different sections of the laser for maximal single mode power. Shown in Fig. 1B is the NS laser device 100, and in particular a top view thereof-that is, when viewed from the top and in the longitudinal direction.

As viewed from the top, the NS laser device 100 may be functionally divided into 3 zones: 1) filter mode (region) 150, 2) transition region 160, and 3) amplifier region 170. In this regard, the filter mode (region) 150 corresponds to the back section of the NS laser device 100, where the waveguide is narrower, and as such the waveguide may strictly support only one mode-namely, a mode filter. The amplifier region 170 corresponds to the front section of the NS laser device 100, where the waveguide is wider, and as such the waveguide may support a few modes intrinsically. The transition region 160 corresponds to the section in between, in which there is a transition between the two different optical mode profiles, namely the ones in the narrow and the wide sections. The transition region 160 may act as a mode coupler between narrow mode filter and wide amplifier section. The transition region 160 may be designed in the way to minimize optical loss.

In various implementations, NS laser devices such as the NS laser device 100 may provide 1.5 W of single mode power (e.g., as kink free power or linear power), within particular temperature range (e.g., between 20 °C and 80 °C). Linear power may also strongly depend on the front mirror reflectivity or on the effective feedback in the case of an external cavity laser.

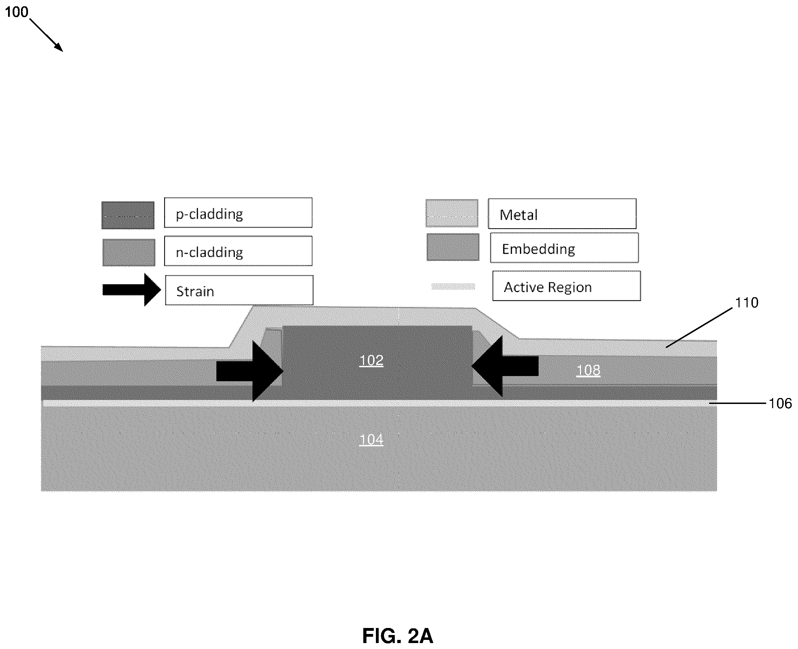

In some instances, in designs used in implementing NS laser devices (e.g., one similar to the one illustrated in Fig. 1A) some level of stress may be imparted onto the semiconductor, which may in turn affect performance or operation of the NS laser devices. This is illustrated in and described in more detail with respect to Figs. 2A-2B.

Fig. 2A illustrates a cross section of an example high power narrow stripe (NS) laser device, showing forces that may be applied onto the semiconductor material. Shown in Fig. 2A is the NS laser device 100, as described with respect to Figs. 1A-1B.

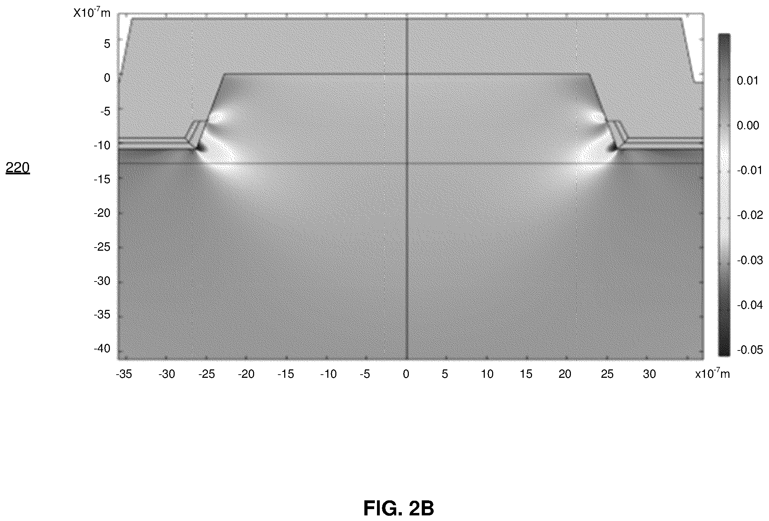

In this regard, as illustrated in Fig. 2A, in some instances the embedding 108 may apply force on the semiconductor material (e.g., a combination of the p-cladding 102, the n-cladding 104, and the active region 106), particularly at or near the ridge area. This force may manifest as stress (or mechanical strain), which may adversely affect performance in the NS laser device. For example, such stress may affect (e.g., modifies) the optical mode in the NS laser device. In this regard, the mechanical strain may introduce a variation in the bandgap as a function of position inside the semiconductor. The change of the bandgap modifies the dielectric function of the semi-conductor, and thus the bandgap change may be translated into a position dependent variation of the refractive index due to the Kramers-Krönig relation. As the embedding 108 layer is deposited directly on the semiconductor, it is relatively close to the active region (e.g., ~few 100s nm from the QW), and as such the effect may be large enough to introduce measurable difference in the optical mode profile. This is illustrated in Fig. 2B.

Fig. 2B illustrates a relative change of the refractive optical index introduced by stress at the ridge area in an example high power narrow stripe (NS) laser device. Shown in Fig. 2B is graph 220, which illustrates the relative change of the refractive optical index introduced by stress at the foot of the ridge in an NS laser device, such as the NS laser device 100. In this regard, the data used in generating the graph 200 may be obtained by measuring the etch depth that ensures single mode operation of the waveguide is moved by ~50 nm for each 1 GPa of added strain by the embedding 108. As illustrated in graph 220, the stress applied by the embedding at or near the ridge, and in particular at the foot of the ridge, may degrade performance.

Solutions in accordance with the present disclosure may overcome the limitations and/or issues that may arise with existing designs, particularly with respect to presence of stress or strains that may affect operation (e.g., optical mode) of NS laser devices. In particular, in various implementations based on the present disclosure, a modified design/structure may be used, in which the embedding layer may be modified, and/or additional patterning of the layers may be introduced. In this regard, one feature in such implementations is that the strain caused and/or applied by the modified embedding layer varies with the position longitudinally. This allows the waveguide properties to be fine-tuned. For example, in some implementations, more compressive strain (referred to hereinafter as "strain level A" or simply "strain A") embedding may be introduced in the front part of the device compared to the embedding at the back part of the device (referred to hereinafter as "strain level B" or simply "strain B"). Such design differs from conventional designs that use a uniform embedding, with single strain embedding (e.g., similar to the strain B) on the whole laser length and standard etch depth. Example embodiments based on the present disclosure and expected effects thereof are illustrated and described in more detail below.

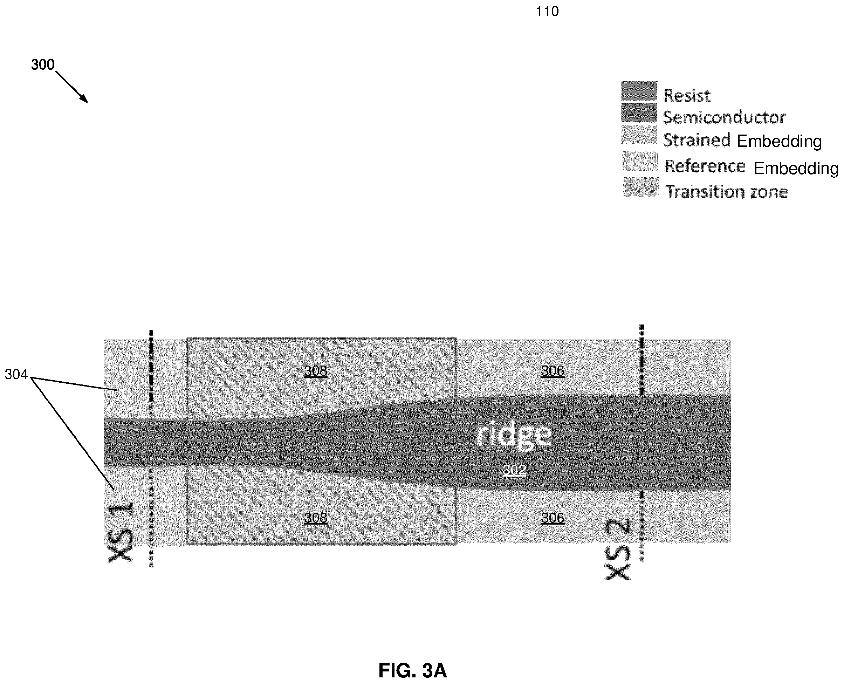

Figs. 3A-3C illustrate schematics of an example two embedding narrow stripe (NS) laser device, with an example process flow to get the desired layers. Shown in Figs. 3A-3C is a two embeddings narrow stripe (NS) laser device 300 implemented based on the present disclosure, as well as various cross sections therein and an example process for forming thereof.

As shown in Figs. 3A-3C, the NS laser device 300 comprises an optical waveguide comprising semiconductor material (e.g., p-cladding, n-cladding, and active material between the two claddings, as described with respect to NS laser device 100 of Fig. 1A), which may be arranged in form of a ridge 302. The NS laser device 300 further comprises reference embedding 304 and a strain embedding 306, with a transition zone 308 in between the two embedding sections. While not shown in Fig. 3A, the NS laser device 300 further comprises a metal contact layer (identified in the figures as "resist") 310 that covers at a least a portion of a top side of the NS laser device 300.

In this regard, as noted above, in accordance with the present disclosure, narrow stripe (NS) laser devices may be implemented using modified designs/structures that address issues arising from stress that may otherwise materialize at areas near the semiconductor layer (particularly near the ridge waveguide), which would affect performance of the device. For example, in various implementations, narrow stripe (NS) laser devices based on the present disclosure may utilize a two embedding based structure, comprising two different embedding materials configured to handle different strains (e.g., strain A embedding and strain B embedding).

In the back part of the laser device, the waveguide is not affected by any strain changes, and as such provided that only one mode is confined inside the waveguide, the laser device may retain its single mode behavior. In contrast, in the front section of the laser device the waveguide, which is not monomode in a standard device, may support only single mode. This may be achieved by incorporating embedding(s) adaptively configured to address the issues otherwise caused by added stress, such as by choosing the appropriate value of this extra compressive stress, which may weaken the waveguide properties until it supports only one mode. For example, the reference embedding 304 may comprise strain level B based embedding material whereas the strain embedding 306 may comprise strain level A based embedding material.

Accordingly, due to the use of such a two-embedding design, the waveguide may be made single mode for each longitudinal position along the whole cavity length by engineering the strain impeded as a function of the waveguide width. Doing so allows for pushing the linear power to higher values.

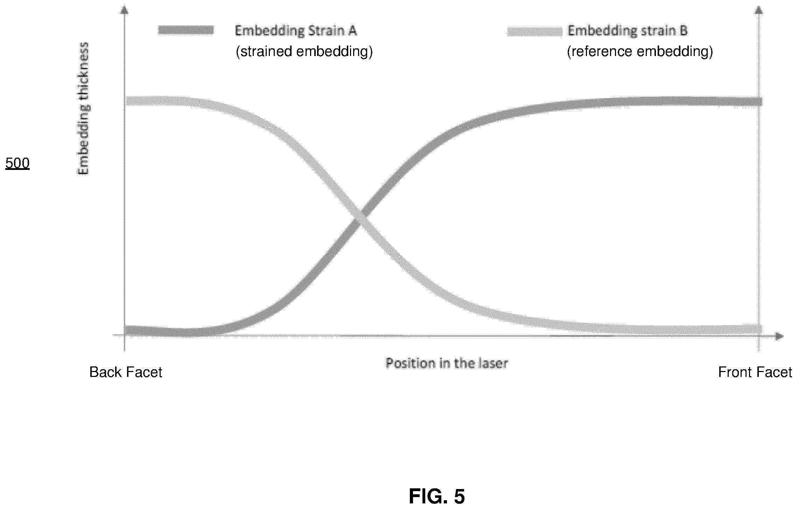

In between the two sections, a transition zone 308 may exist. In this regard, a transition between the optical modes is needed as the difference of strain may create a modification of the waveguide, which may create parasitic reflections inside the waveguide. Different schemes may be used in achieving this mode transition (and thus, the transition zone 308). The transition zone 308 may comprise a combination of both embedding materials. Further, in some instances, the relative amounts of the two embedding materials may vary, such as progressively from one end of the laser device to the other end, as illustrated and described in more detail with respect to Fig. 5.

The two-embedding based designs may be implemented in various ways, and the disclosure is not limited to any particular approach. Rather, it should be understood that any suitable approach may be used. For example, in one example implementation, which may represent the most straightforward implementation, the two-embedding structure may be implemented by lithographically patterning two embeddings with two different strains. In the first step of such a lithographically patterning based process, compressively strained embedding (e.g., strain level A) may be deposited, such as using a plasma-enhanced chemical vapor deposition (PECVD) based technique or an atomic layer deposition (ALD) based technique, then depositing and patterning a resist layer, and then removing this embedding layer on the back of the device (e.g., using lithographic opening and embedding etching and stripping). In the second step of the process, with another mask level, one would deposit the embedding with strain level B, pattern it again with a mask that is the negative of the first one, and remove the embedding deposited on the front part of the device (e.g., using lithographic opening and embedding etching and stripping). In other words, the process may comprise a main first step and second step for applying the embedding regions, with each of the first step and second step comprising one or more sub-steps. The one or more sub-steps may comprise, e.g., depositing embedding material (either strained or reference embedding material), then applying the resist (metal contact) layer, then lithographing and opening, then embedding etching and stripping.

An alternative but more complex process for depositing the embedding that may be used is pulsed laser deposition (PLD). In this regard, PLD is a scanning technique, and as such the thicknesses deposited may be modulated on the laser length scale. One may deposit a thick layer of embedding with strain A in the front part of the laser device, and a very thin layer on the back. In a second step, one may do the exact opposite, deposit a thick embedding with strain B in the back and thin embedding with Strain A in the front.

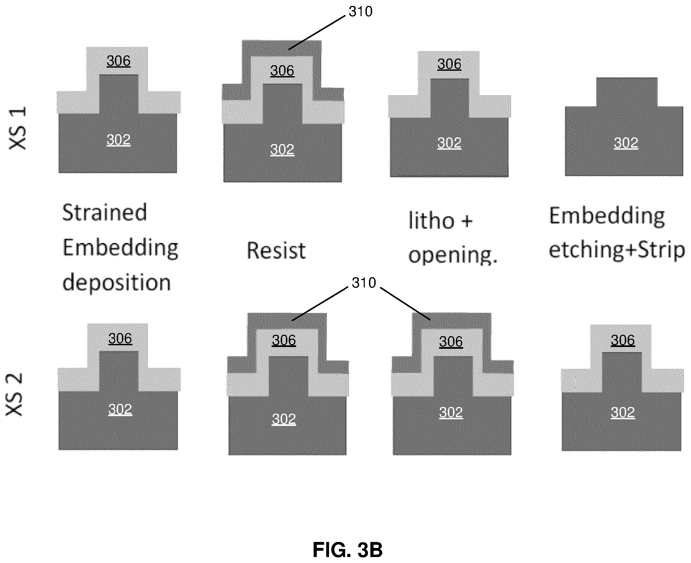

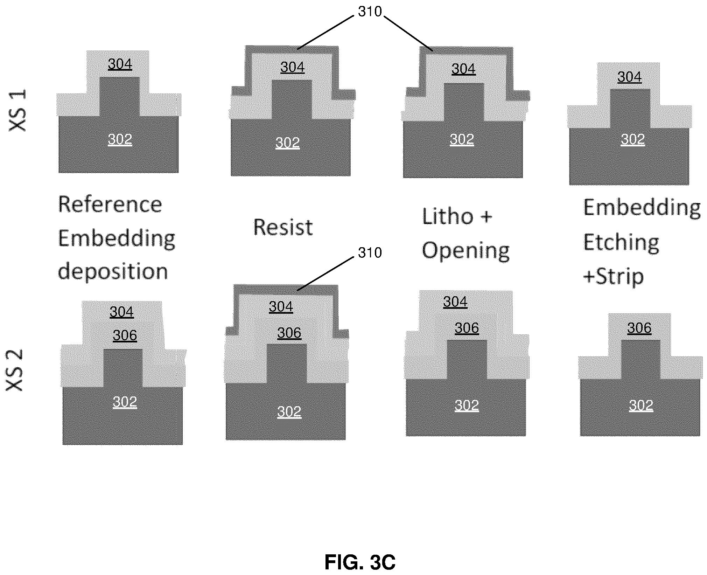

Example snapshots of the cross section of the laser device are shown in Figs. 3B and 3C, during the different process steps. In particular, as illustrated in Figs. 3B and 3C, the snapshots may correspond to two different cross section in the laser device: 1) first cross-section (XS1) near the back-section of the device, and 2) second cross-section (XS2) near the front-section of the device. The different snapshots shown in Figs. 3B and 3C correspond to different points during the forming process. In particular, as shown, Fig. 3B corresponds to the first step and Fig. 3C corresponds to the second step in the lithographically patterning based process (with example sub-steps performed during these steps), as described above.

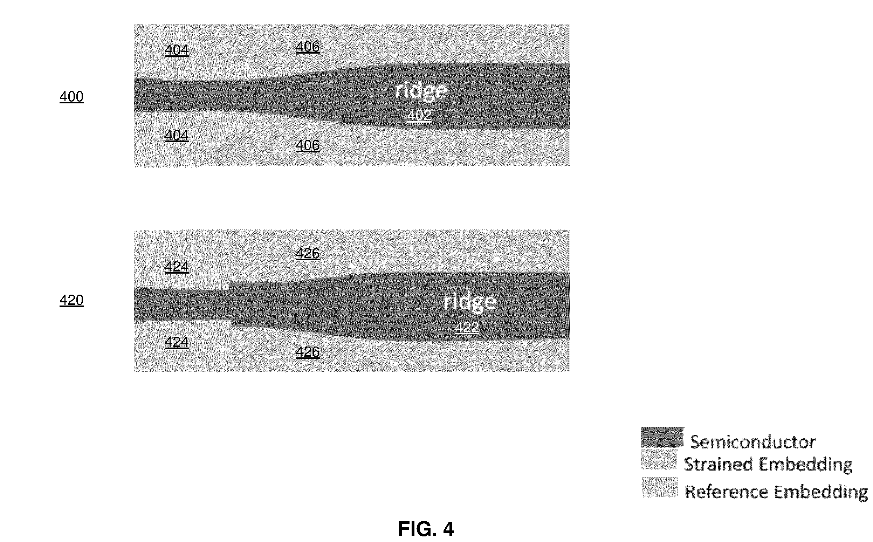

Fig. 4 illustrates schematics of an example two embedding narrow stripe (NS) laser device, with an example process flow to get the desired layers. Shown in Fig. 4 are narrow stripe (NS) laser devices 400 and 420.

Each of the NS laser devices 400 and 420 incorporates a two embeddings based design implemented in accordance with the present disclosure, and may be substantially similar to the NS laser device 300 of Figs. 3A-3C. As such, the NS laser device 400 comprises semiconductor/ridge 402, a reference embedding 404, and a strain embedding 406, whereas the NS laser device 420 comprises semiconductor/ridge 422, a reference embedding 424, and a strain embedding 426, with each of the elements being substantially similar to similarly-named elements in the NS laser device 300.

However, the NS laser devices 400 and 420 may represent alternative implementations differing with respect to the transition between the reference embedding and the strain embedding. In this regard, as illustrated in Fig. 4, the NS laser device 400 may have a more gradual and tapered transition from the reference embedding to the strained embedding, such as through the patterning of the embeddings, which may allow for progressively reducing the strain around the waveguide, whereas the NS laser device 420 may have a more abrupt transition, with a step in the ridge waveguide that may be made to match the transition in the strain.

Fig. 5 is graph illustrating an example alternate implementation with pulsed laser deposition (PLD) technique. Shown in Fig. 5 is graph 500 illustrating the layer thickness of the embedding layer in an example narrow stripe (NS) laser device with two embeddings implemented based on the present disclosure. In particular, shown in graph 500 is the composition of the embedding layers in terms of material corresponding to the two embeddings (strained embedding, comprising, e.g., strain A embedding, and reference embedding comprising, e.g., strain B embedding) throughout the length of the NS laser device. In this regard, as illustrated in graph 500, there may be a gradual transition (in terms of percentage of the overall thickness) from mostly strain B embedding at the back facet of the NS laser device to mostly strain A embedding at the front facet of the NS laser device. Use of such a gradual transition may be achieved by use of a pulsed laser deposition (PLD) technique. In some instances, various aspects of the transition in the layers thickness may be tuned to produce a particular required stress field. The graph 500 illustrates example transition profile(s) which may produce such required stress field.

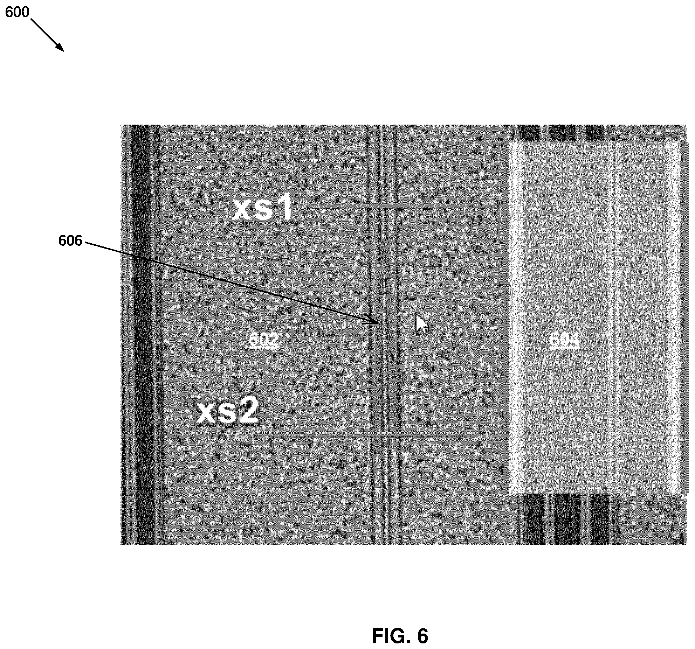

Fig. 6 illustrates an optical microscope image of the transition between the two patterned embeddings in an example two embedding narrow stripe (NS) laser device. Shown in Fig. 6 is narrow stripe (NS) laser device 600 (or portion thereof) incorporating two-embedding based structure based on the present disclosure, illustrating the transition between the two embeddings (602 and 604) therein.

In this regard, illustrated in Fig. 6 is a top view of an optical microscope image of such a NS laser device (and transition region therein). In particular, as illustrated in Fig. 6, in a first step, a patterning of the embeddings (embeddings 602 and 604) may be seen with careful visual inspection of the device without any removal of the metal layers on top of them. The transition region 606 between the two embeddings 602 and 604 may not be completely buried below the metal, as shown in optical microscope image in Fig. 6. Also illustrated are a first cross-section (XS1) in the front section of the device and a second cross-section (XS2) through the transition region. Typically, a change a color of the embedding layer between the different regions may be expected and/or observed. Such color steps may be visible in most of the configurations of the present disclosure, but not necessarily all of them. Even without removing the metal contact layer, the limit between the two embeddings (embeddings 602 and 604) may be seen, because of some topography remaining at the interface between the two materials, as illustrated in the example optical microscope image in Fig. 6.

In some instances, improvements provided by solutions based on the present disclosure may be assessed, such as by testing. In this regard, the testing may comprise measuring the strain introduced by thin film on processed devices, to verify that stress in NS laser device implemented based on the present disclosure is different in the front part of the laser device than on the back part of the laser device. To that end, there may be various techniques to measure the stress of the thin film, and the disclosure is not limited to any particular testing technique, and as such any suitable testing technique may be used.

An example narrow stripe optical emitter device, in accordance with the present disclosure, comprises: an active region comprising semiconductor material; a first embedding region located on a first end of the narrow stripe optical emitter device, where the first embedding region comprises a first embedding material; and a second embedding region located on a second end of the narrow stripe optical emitter device, where the second embedding region comprises a second embedding material; where the active region comprises a ridge running between the first end and the second end of the narrow stripe optical emitter device; where the first embedding material different from the second embedding material with respect to one or more characteristics; and where the one or more characteristics comprise, at least, compressive strain related parameters and/or attributes.

In an example embodiment, the narrow stripe optical emitter device further comprises a transition region between the first embedding region and the second embedding region.

In an example embodiment, the transition region comprises both the first embedding material and the second embedding material.

In an example embodiment, relative amounts of the first embedding material and the second embedding material within the transition region vary between the first end to the second end.

In an example embodiment, an amount of the first embedding material decreases and an amount of the second embedding material increases in a direction from the first end to the second end.

In an example embodiment, a combined total of an amount of the first embedding material decreases and an amount of the second embedding material is constant from the first end to the second end. In some instances, only one of the two embedding material may be patterned (e.g., the patterned material being absent at one end of the device, fully covering the other end and making a transition between the two lithographically.

In an example embodiment, the first end comprises one of a front-section and a back-section of the narrow stripe optical emitter device, and the second end comprises other one of the front-section and the back-section of the narrow stripe optical emitter device.

In an example embodiment, the semiconductor material comprises p-type doped (p-cladding), n-type doped cladding (n-cladding), and active material. **In** this regard, the order of the p-cladding and the n-cladding is not relevant or pertinent.

In an example embodiment, the active region comprises one or more quantum well (QW).

In an example embodiment, the narrow stripe optical emitter device further comprises a metal contact layer covering at least a portion of a top side of the narrow stripe optical emitter device.

In an example embodiment, the narrow stripe optical emitter device is a narrow stripe single mode transverse laser device.

An example method for making a narrow stripe optical emitter device, in accordance with the present disclosure, comprises: forming an active region comprising semiconductor material, where forming the active region comprises forming a ridge running between the first end and the second end of the narrow stripe optical emitter device; forming a first embedding region on a first end of the narrow stripe optical emitter device, wherein the forming comprises applying a first embedding material; and forming a second embedding region on a second end of the narrow stripe optical emitter device, where the forming comprises applying a second embedding material; and where the first embedding material is different from the second embedding material with respect to one or more characteristics; and where the one or more characteristics comprise, at least, compressive strain related parameters and/or attributes.

In an example embodiment, the method further comprises forming a transition region between the first embedding region and the second embedding region.

In an example embodiment, the method further comprises forming the transition region such that the transition region comprises both the first embedding material and the second embedding material.

In an example embodiment, the method further comprises forming the transition region such that relative amounts of the first embedding material and the second embedding material within the transition region vary between the first end to the second end.

In an example embodiment, the method further comprises forming the transition region such that an amount of the first embedding material decreases and an amount of the second embedding material increases in a direction from the first end to the second end.

In an example embodiment, the method further comprises forming the transition region such that a combined total of an amount of the first embedding material decreases and an amount of the second embedding material is constant from the first end to the second end. In some instances, only one of the two embedding material may be patterned (e.g., the patterned material being absent at one end of the device, fully covering the other end and making a transition between the two lithographically.

In an example embodiment, the method further comprises applying a metal contact layer to at least a portion of a top side of the narrow stripe optical emitter device.

In an example embodiment, the method further comprises performing one or more of the forming of the active region, the forming of the first embedding region, and the forming of the second embedding region based on a deposition technique.

In an example embodiment, the deposition technique comprises one or more of plasma-enhanced chemical vapor deposition (PECVD) or atomic layer deposition (ALD), and pulsed laser deposition (PLD).

In implementations described herein, systems and methods are provided for patterned embedding on narrow stripe single mode transverse lasers. An example narrow stripe optical emitter device may include an active region containing semiconductor material, a first embedding region located on a first end of the narrow stripe optical emitter device and containing a first embedding material, and a second embedding region located on a second end of the narrow stripe optical emitter device and containing a second embedding material. The active region may include a ridge running between the first end and the second end of the narrow stripe optical emitter device. The first embedding material may be different from the second embedding material with respect to one or more characteristics. The one or more characteristics may include compressive strain related parameters and/or attributes.

The present application claims priority of U.S. patent application 18/971,840 filed on December 6, 2024. The entire disclosure content of this application is incorporated herein for all purposes.

In the following, a set of items is disclosed. The items are numbered to facilitate referencing the features of one item in other items. The items form part of the present disclosure and could be made subject to independent and/or dependent claims irrespective of what currently is claimed in the application. We note, however, that the scope of protection is defined by the appended claims, where the following items do not constitute claims. The items are:
1. A narrow stripe optical emitter device comprising:
   an active region comprising semiconductor material;
   a first embedding region located on a first end of the narrow stripe optical emitter device, wherein the first embedding region comprises a first embedding material; and
   a second embedding region located on a second end of the narrow stripe optical emitter device, wherein the second embedding region comprises a second embedding material;
   wherein the active region comprises a ridge running between the first end and the second end of the narrow stripe optical emitter device;
   wherein the first embedding material different from the second embedding material with respect to one or more characteristics; and
   wherein the one or more characteristics comprise, at least, compressive strain related parameters and/or attributes.
2. The narrow stripe optical emitter device of item 1, further comprising a transition region between the first embedding region and the second embedding region.
3. The narrow stripe optical emitter device of item 2, wherein the transition region comprises both the first embedding material and the second embedding material.
4. The narrow stripe optical emitter device of item 3, wherein relative amounts of the first embedding material and the second embedding material within the transition region vary between the first end to the second end.
5. The narrow stripe optical emitter device of item 4, wherein an amount of the first embedding material decreases and an amount of the second embedding material increases in a direction from the first end to the second end.
6. The narrow stripe optical emitter device of item 3, wherein a combined total of an amount of the first embedding material varies spatially and an amount of the second embedding material is constant from the first end to the second end.
7. The narrow stripe optical emitter device of item 1, wherein the first end comprises one of a front-section and a back-section of the narrow stripe optical emitter device, and the second end comprises other one of the front-section and the back-section of the narrow stripe optical emitter device.
8. The narrow stripe optical emitter device of item 1, wherein the semiconductor material comprises p-type doped cladding (p-cladding), n-type doped cladding (n-cladding), and active material.
9. The narrow stripe optical emitter device of item 1, wherein the active region comprises one or more quantum well (QW).
10. The narrow stripe optical emitter device of item 1, further comprising a metal contact layer covering at least a portion of a top side of the narrow stripe optical emitter device.
11. The narrow stripe optical emitter device of item 1, wherein the narrow stripe optical emitter device is a narrow stripe single mode transverse laser device.
12. A method for making narrow stripe optical emitter device, the method comprising:
   forming an active region comprising semiconductor material, wherein forming the active region comprises forming a ridge running between the first end and the second end of the narrow stripe optical emitter device;
   forming a first embedding region on a first end of the narrow stripe optical emitter device, wherein the forming comprises applying a first embedding material; and
   forming a second embedding region on a second end of the narrow stripe optical emitter device, wherein the forming comprises applying a second embedding material; and
   wherein the first embedding material different from the second embedding material with respect to one or more characteristics; and
   wherein the one or more characteristics comprise, at least, compressive strain related parameters and/or attributes.
13. The method of item 12, further comprising forming a transition region between the first embedding region and the second embedding region.
14. The method of item 13, further comprising forming the transition region such that the transition region comprises both the first embedding material and the second embedding material.
15. The method of item 14, further comprising forming the transition region such that relative amounts of the first embedding material and the second embedding material within the transition region vary between the first end to the second end.
16. The method of item 15, further comprising forming the transition region such that an amount of the first embedding material decreases and an amount of the second embedding material increases in a direction from the first end to the second end.
17. The method of item 14, further comprising forming the transition region such that a combined total of an amount of the first embedding material decreases and an amount of the second embedding material is constant from the first end to the second end.
18. The method of item 12, further comprising applying a metal contact layer to at least a portion of a top side of the narrow stripe optical emitter device.
19. The method of item 12, comprising performing one or more of the forming of the active region, the forming of the first embedding region, and the forming of the second embedding region based on a deposition technique.
20. The method of item 12, wherein the deposition technique comprises one or more of plasma-enhanced chemical vapor deposition (PECVD) or atomic layer deposition (ALD), and pulsed laser deposition (PLD).

As utilized herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z." As utilized herein, the term "exemplary" means serving as a non-limiting example, instance, or illustration. As utilized herein, the terms "for example" and "e.g." set off lists of one or more non-limiting examples, instances, or illustrations.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A narrow stripe optical emitter device comprising:
an active region comprising semiconductor material;
a first embedding region located on a first end of the narrow stripe optical emitter device, wherein the first embedding region comprises a first embedding material; and
a second embedding region located on a second end of the narrow stripe optical emitter device, wherein the second embedding region comprises a second embedding material;
wherein the active region comprises a ridge running between the first end and the second end of the narrow stripe optical emitter device;
wherein the first embedding material different from the second embedding material with respect to one or more characteristics; and
wherein the one or more characteristics comprise, at least, compressive strain related parameters and/or attributes.

2. The narrow stripe optical emitter device of claim 1, further comprising a transition region between the first embedding region and the second embedding region.

3. The narrow stripe optical emitter device of claim 2, wherein the transition region comprises both the first embedding material and the second embedding material.

4. The narrow stripe optical emitter device of claim 3, wherein relative amounts of the first embedding material and the second embedding material within the transition region vary between the first end to the second end.

5. The narrow stripe optical emitter device of claim 4, wherein an amount of the first embedding material decreases and an amount of the second embedding material increases in a direction from the first end to the second end.

6. The narrow stripe optical emitter device of any one of claims 3 to 5, wherein a combined total of an amount of the first embedding material varies spatially and an amount of the second embedding material is constant from the first end to the second end.

7. The narrow stripe optical emitter device of any one of the preceding claims, wherein the first end comprises one of a front-section and a back-section of the narrow stripe optical emitter device, and the second end comprises other one of the front-section and the back-section of the narrow stripe optical emitter device.

8. The narrow stripe optical emitter device of any one of the preceding claims, wherein
a) the semiconductor material comprises p-type doped cladding (p-cladding), n-type doped cladding (n-cladding), and active material, and/or wherein
b) the active region comprises one or more quantum well (QW), and/or wherein
c) the narrow stripe optical emitter device further comprises a metal contact layer covering at least a portion of a top side of the narrow stripe optical emitter device.

9. The narrow stripe optical emitter device of any one of the preceding claims, wherein the narrow stripe optical emitter device is a narrow stripe single mode transverse laser device.

10. A method for making narrow stripe optical emitter device, the method comprising:
forming an active region comprising semiconductor material, wherein forming the active region comprises forming a ridge running between the first end and the second end of the narrow stripe optical emitter device;
forming a first embedding region on a first end of the narrow stripe optical emitter device, wherein the forming comprises applying a first embedding material; and
forming a second embedding region on a second end of the narrow stripe optical emitter device, wherein the forming comprises applying a second embedding material; and
wherein the first embedding material different from the second embedding material with respect to one or more characteristics; and
wherein the one or more characteristics comprise, at least, compressive strain related parameters and/or attributes.

11. The method of claim 10, further comprising forming a transition region between the first embedding region and the second embedding region, wherein, optionally, the method further comprises forming the transition region such that the transition region comprises both the first embedding material and the second embedding material, wherein, for example, the method further comprises forming the transition region such that relative amounts of the first embedding material and the second embedding material within the transition region vary between the first end to the second end.

12. The method of claim 11, further comprising forming the transition region such that an amount of the first embedding material decreases and an amount of the second embedding material increases in a direction from the first end to the second end, wherein, optionally, the method further comprises forming the transition region such that a combined total of an amount of the first embedding material decreases and an amount of the second embedding material is constant from the first end to the second end.

13. The method of any one of claims 10 to 12, further comprising applying a metal contact layer to at least a portion of a top side of the narrow stripe optical emitter device.

14. The method of any one of claims 10 to 13, comprising performing one or more of the forming of the active region, the forming of the first embedding region, and the forming of the second embedding region based on a deposition technique.

15. The method of claim 14, wherein the deposition technique comprises one or more of plasma-enhanced chemical vapor deposition (PECVD) or atomic layer deposition (ALD), and pulsed laser deposition (PLD).
